# EUROPEAN PATENT SPECIFICATION

(11) **EP 2 356 702 B1**
(45) Date of publication and mention of the grant of the patent: **22.11.2017**
(21) Application number: 09753227.9
(22) Date of filing: 30.10.2009
(51) Int. Cl.: H01L 33/50, C09K 11/77, A01G 7/04, H05B 33/14, C09K 11/68, C09K 11/64

(54) **PHOSPHOR CONVERSION LIGHT-EMITTING DIODE FOR MEETING PHOTOMORPHOGENETIC NEEDS OF PLANTS**
LEUCHTDIODE MIT WELLENLÄNGENKONVERSION ENTSPRECHEND DEN PHOTOMORPHOGENETISCHEN BEDÜRFNISSEN VON PFLANZEN
DIODE ÉLECTROLUMINESCENTE À CONVERSION DE SUBSTANCE FLUORESCENTE POUR RÉPONDRE AUX BESOINS PHOTOMORPHOGÉNÉTIQUES DES PLANTES

(30) Priority: 07.11.2008 LT 2008084
(43) Date of publication of application: 17.08.2011
(73) Proprietor: Uab ''Hortiled'', 44403 Kaunas (LT)
(72) Inventor: ZUKAUSKAS, Arturas, 10219 Vilnius (LT); DUCHOVSKIS, Pavelas, 54334 Babtai Kauno raj. (LT)
(74) Representative: Gerasimovic, Liudmila
(86) International application number: PCT/LT2009/000016
(87) International publication number: WO 2010/053341

(56) References cited:
- CN-A- 101 488 541
- JP-A- 2001 352 101
- JP-A- 2006 012 766
- JP-A- 2009 277 997
- US-A- 5 012 609

## Description

### Technical Field

The invention relates to solid-state sources of light with the emission spectra tailored in order to meet specific needs of plants. In particular, the invention discloses a light-emitting diode, where light generated in a semiconductor chip is partially or completely converted within a wavelength converter comprising a phosphor (a substance, which converts radiation with a shorter wavelength to that with a longer wavelength) that has an emission spectrum with a peak in the far-red region of about from 700 nm to 760 nm, which matches the absorption spectrum of the plant photoreceptor phytochrome of the P_{fr} form.

### Background Art

The present invention is directly connected to artificial lighting for plant cultivation based on solid-state technology.

The photophysiological processes in plants are controlled by phytopigments (chlorophylls, carotenoids, phytochromes, cryptochromes), which efficiently utilize only photons within specific wavelength ranges. In particular, chlorophylls require light in the wavelength range from 620 nm to 680 nm, carotenoinds absorb light in the range around 450 nm, different forms of phytochrome, Pᵣ and P_{fr}, are activated by light in the wavelength ranges around 660 nm and 730 nm, respectively, cryptochromes absorb light in the range from 340 nm to 520 nm [M. S. Mc Donald, Photobiology of Higher Plants (Wiley, Chichester, 2003), xiv+354 p., ISBN 0470855223]. Meanwhile, light with the wavelengths shorter than 400 nm and longer than 800 nm can have a harmful effect on plant morphogenesis. This infers that efficiency of artificial lighting used in plant cultivation can be increased by using sources with a spectrum that contains only narrow bands in blue (around 450 nm), red (around 660 nm), and far-red (around 730 nm) regions.

One of the ways of the optimization of plant illumination spectra was implemented in fluorescent lamps, which are low-pressure mercury vapour discharge lamps with phosphor coating. Ultraviolet (UV) light (254-nm) generated in the discharge can be converted by phosphors to other wavelengths in the same way as in white fluorescent lamps, but with the enhanced emission in the aforementioned spectral regions relevant to plants [US Patents No 3,287,586 (1963); 3,992,646 (1976); 4,371,810 (1983); 5,525,860 (1996); and 7,259,509 (2007)]. However, fluorescent lamps have many drawbacks that prevent them from wide use in plant cultivation.

First, the efficiency of fluorescent lamps has physical limits that are caused by the limited efficiency of the generation of UV light in low-pressure mercury discharge (about 63%) and a large Stokes shift while converting UV light to visible light (i.e., over 40%, 60%, and 65% of energy is inevitably lost when 254-nm light is converted to 450-nm, 660-nm, and 730-nm light, respectively). This results in that the overall efficiency of fluorescent lamps relevant to photosynthesis cannot exceed 25% and in the far-red region this parameter can only approach 22%. Furthermore, fluorescent lamps contain mercury that is a hazardous agent, their efficient lifetime usually does not exceed 20 000 hours, they are fragile, utilize high voltage and emit unwanted infrared light.

Another method of the optimization of plant illumination spectrum, which considerably mitigates the main drawbacks of fluorescent lamps, is the use of solid-state sources of light, light-emitting diodes (LEDs). LEDs are based on the principle of injection electroluminescence, which is the only one known principle of light generation that has no physical limits in efficiency. Therefore, potentially LEDs can by more efficient than other sources of light. Additionally, LEDs are advantageous in mechanical robustness, compactness, longevity (up to 100 000 hours), fast switching, no abrupt failure, low operation voltage (2-4 V), compatibility with computer electronics, narrow-band emission without undesired spectral components, freedom from hazardous materials (mercury), and flexibility in terms of assembling into arrays of different shape. This results in that LED-based solid-state lighting technology is gradually penetrating in all spheres of application of artificial light, including plant cultivation [A. Žukauskas, M. S. Shur, R. Gaska, Introduction to Solid-State Lighting (Wiley, New York, 2002), xii+207 p., ISBN 0471215740].

The spectrum of light emitted by LEDs can be tailored to meet photophysiological needs of plants in several ways. The first way is to directly apply the optoelectronic principle (injection electroluminescence), when the emission wavelength of LEDs is determined by the band gap of the active layer of the LED, which can be varied by tuning the chemical composition of the semiconductor alloy. This allows to exactly matching the narrow-band emission from LEDs with the absorption spectra of phytopigments. Soon after the development of high-brightness red AlGaAs LEDs, the photosynthetic productivity of plants was proposed to increase by illumination using quasi-monochromatic light that match the main peak of chlorophyll absorption spectrum (around 660 nm) in such a way that energy losses that are inherent for absorption of shorter-wavelength light would be avoided [Bula R. J., Morrow R. C., Tibbitts T. W., Barta D. J., Ignatius R. W., Martin T. S., "Light-emitting diodes as a radiation source for plants," HortScience 26 (2), p.203-205 (1991)]. In the subsequent US Patent No 5,012,609 (1991), three spectral ranges were claimed to be covered by an array of coloured LEDs, which supports growth and morphogenesis of plants, namely, 620-680 nm for the meeting of the photosynthetic needs of plants, 700-760 nm for the photomorphogenetic needs, and 400-500 nm for the phototropic and photomorphogenetic needs. Later, other kinds of LEDs emitting green, white, and UV light [US Patent No 6,725,598] as well as orange light [US Patent No 6,921,182] were proposed to be introduced into plant-cultivation LED arrays in order to facilitate specific photophysiological responses of plants.

Although arrays of LEDs emitting at individual wavelengths, which are determined by the band gap energy of the active layer, are highly versatile and potentially efficient illuminators for plant cultivation, they have some inherent drawbacks that are mainly due to assembling of different types of LEDs in a single lamp. For instance, LEDs emitting at different wavelengths usually have different driving voltages that are determined by the semiconductor band gap energy and series resistance. This makes using of power supplies that are common for all groups of LEDs difficult and require separate driving circuits for each type of LEDs. Second, different types of LEDs have different thermal coefficients of output and different degradation rates. Such uneven thermal and aging drifts of LEDs result in the variation of the fractional photon flux of various spectral components with temperature ant operating time. In particular, emission efficiency in AlGaAs and AlGalnP semiconductors that are used in red LEDs is highly sensitive to temperature due to the presence of indirect valleys in the conduction band, differently from blue InGaN LEDs that do not suffer from this drawback. Third, the manufacturing process of some semiconductors, such as AlGaAs and AlGalnP, requires using of highly toxic agents (arsenic As, arsine AsH₃, and phosphine PH₃), which are environmentally undesirable.

An alternative method of solid-state lighting is the use of phosphor-conversion LEDs. In phosphor-conversion LEDs, the injection electroluminescence principle is supplemented by the photoluminescence principle, when the short-wavelength (blue or near-UV) emission generated in the semiconductor chip is partially or completely converted to emission with a required wavelength by means of a wavelength converter containing an appropriate phosphor. Such LEDs are solid-state counterparts of fluorescent lamps; however, they have numerous advantages in respect of both fluorescent lamps and purely electroluminescent coloured LEDs. Comparing to fluorescent lamps, they can have much higher efficiencies, since the efficiency of the primary source of light is no more limited by physical factors and can approach 100%. Besides, owing to a longer wavelength of light, generated in the primary source, the efficiency of light conversion can be higher. For instance, when converting light from 450-nm wavelength to 730-nm and 660-nm wavelengths, the conversion efficiency can attain 62% and 68%, respectively. Meanwhile, in comparison with arrays of purely electroluminescent LEDs, phosphor-converted LEDs allow avoiding use of AlGaAs and AlGalnP LEDs, which are sensitive to temperature and have limited efficiency. Since phosphor-conversion LEDs can by manufactured basing on a single type of semiconductor, such as InGaN, the driving voltage of the LEDs that emit light with different wavelengths can be unified. Also, the nonmetal nitrogen (N) precursor used in the manufacturing process of InGaN LEDs usually is ammonia (NH₃), which is much less toxic than the precursors of arsenic (As) and phosphor (P) used in the manufacturing process of AlGaAs and AlGalnP LEDs. Besides, LEDs based on InGaN alloy are more longevous than AlGaAs and AlGalnP counterparts, since their active layer contains no chemically reactive aluminium (Al). Finally, phosphor-conversion LEDs allow generating light with several narrow-band components by using a single semiconductor chip and a single power supply.

Similarly to fluorescent lamps, common phosphor-conversion LEDs are used for the generation of white light. In white LEDs with partial conversion [US Patent No 5,998,925 (1999)], a portion of blue light generated by an InGaN semiconductor chip is converted to yellow light using a garnet-type phosphor activated by trivalent cerium ions. The resulting mixture of blue and yellow light is perceived by human eye as white light. In white LEDs with complete conversion [US Patent No 6,084,250 (2000)], a semiconductor chip that emits near-UV light and a blend of phosphors with different chemical composition that emit red, green, and blue light are used. White phosphor-conversion LEDs are widely used in liquid-crystal display backlighting, signage, illumination, and measurement technology. Such LEDs are also sometimes incorporated into LED arrays for plant cultivation as sources of additional spectral components, such as yellow [US patent No 6,725,598 (2004)]. Most part of white phosphor-conversion LEDs emit one or several spectral components that are suitable for meeting some photophysiological needs of plants. For instance in all white LEDs with partial conversion [e.g., US Patents No 5,998,925 (1999); 6,252,254 (2001); 6,501,102 (2002); 6,504,179 (2003); 6,982,045 (2006); 7,038,370 (2006)], the primary spectral component, which is generated by the InGaN semiconductor chip, has a peak in the blue region between 400 nm and 500 nm, which matches the absorption spectra of carotenoids and cryptochromes. The blue region of the spectra is also covered by most white LEDs with complete conversion, which employ such phosphors as BaMgAl₁₀O₁₇:Eu²⁺ [US Patent No 6,084,250 (2000)], (Sr,Ba,Ca)₅(PO₄)₃Cl:Eu²⁺ and BaMg₂Al₁₆O₂₇:Eu²⁺ [US Patent No 6,294,800 (2001)], La₃Si₆N₁₁:Ce³⁺ and SrSiAl₂O₃N₂:Ce³⁺ [US Patent No 6,670,748 (2003)], and others. Some white partial-conversion LEDs have wavelength converters that emit in the red region between 620 nm and 680 nm, which matches the optical absorption of chlorophylls and phytochrome of the Pᵣ form. For this purpose, such phosphors as Y₂O₂S:Eu³⁺,Bi³⁺, YVO₄:Eu³⁺,Bi³⁺ and SrY₂S₄:Eu²⁺ [US Patent No 6,252,254 (2001)], SrS:Eu²⁺ [US Patent No 6,501,102 (2002)], CaS:Eu²⁺ and Sr₂Si₅N₈:Eu²⁺ [US Patent No 7,038,370 (2006)] are used. Many white LEDs with complete conversion also emit in the same red region of the spectrum, which is important for plants. For this purpose, such phosphors as Y₂O₃:Eu³⁺,Bi³⁺ [US Patent No 6,294,800 (2001)], MgO·MgF₂·GeO₂:Eu²⁺ [US Patent No 6,621,211 (2003)], Sr₂Si₄AlON₇:Eu²⁺ [US Patent No 6,670,748 (2003)] are used.

The latter category of oxynitride phosphors can be exactly tailored to the absorption spectrum of chlorophylls.

However, common white phosphor-conversion LEDs are not able to completely meet photophysiological needs of plants, since they are designed for visual applications and lack a spectral component in the far-red (700-760 nm) range, which is necessary for the reverse excitation of phytochrome of the P_{fr} form. In visual-application LEDs, the far-red spectral component is avoided, since red light with wavelengths longer than 660 nm has low luminous efficacy of radiation, i.e., the sensitivity of eye in this range is low in comparison with 640-660 nm spectral range, where colour perception of red light is almost the same. Meanwhile, the reverse excitation of phytochrome plays a key role in many photomorphogenetic processes, such as establishing of the circadian cycle, shooting, control of stem height and number and shape of leaves, flowering, synthesis of chlorophyll, etc.

The prior art closest to the proposed phosphor conversion LED for meeting photomorphogenetic needs of plants is the aforementioned white LED based on an InGaN semiconductor chip and trivalent-cerium activated garnet disclosed in the US Patent No 5,998,925 (1999) considered above.

However, this LED is incapable of complete meeting photomorphogenetic needs of plants, since it is designed for visual applications and lacks a spectral component in the far-red region (700-760 nm), which is necessary for the reverse excitation of P_{fr} phytochrome.

JP 2001 352101 A (NICHIA KAGAKU KOGYO KK; 21 December 2001) discloses a light emitting diode according to the preamble of claim 1, which is used as a light source for plant cultivation.

### Summary of Invention

The present invention is defined in claim 1. The aim of the invention is to develop phosphor-conversion LEDs with either partial conversion of blue light or complete conversion of near-UV light in a wavelength converter in such a way that the resulting emission would contain a spectral component with a peak in the 700-760 nm wavelength range, which is necessary for the excitation of P_{fr} phytochrome.

This aim is achieved by using a light-emitting diode (LED) comprising a package housing a semiconductor chip, which generates short-wavelength emission at a wavelength shorter than 500 nm due to injection electroluminescence, and a converter, placed on the way of the photon flux generated by the chip, the said converter being designed for the conversion of the said emission to longer-wavelengths due to photoluminescence and containing phosphor particles of at least one type. The converter comprises a phosphor, emitting within a spectral band, peaking in the far-red region from 700 nm to 760 nm, which corresponds to the absorption spectrum of phytochrome of the P_{fr} form, the phosphor being
- gadolinium-gallium oxide activated by trivalent chromium and/or trivalent cerium ions, or
- calcium sulphide activated by divalent ytterbium ions.

In an LED with partial conversion, the semiconductor chip generates blue light in the spectral range of 400-500 nm, which meets photomorphogenetic and phototropic needs of plants, and the converter is distinguished by partial conversion of said light to longer-wavelength light, when the wavelength converter has a phosphor that partially converts blue light to only far-red light or several phosphors that partially convert blue light to red light and far-red light.

In an LED with complete conversion, the semiconductor chip generates near-UV light or violet light or blue light with a wavelength shorter than 500 nm and the converter is distinguished by complete conversion of said light to longer-wavelength light.

In both partial-conversion and complete-conversion LEDs, the converter may have a supplementary phosphor that emits red light in the 620-680 nm spectral range, which meets the photosynthetic and photomorphogenetic needs of plants, such as oxide, halooxide, chalcogenide, or nitride compound activated by divalent or tetravalent manganese, divalent or trivalent europium, trivalent bismuth, or divalent tin ions.

In complete conversion LEDs, the converter may have a supplementary phosphor that emits blue light in the 400-500 nm spectral range, which meets the photomorphogenetic and phototropic needs of plants, such as oxide, halooxide, or nitride compound activated by divalent europium, divalent manganese, divalent tin, or trivalent cerium ions.

In partial conversion LEDs, the wavelength converter has either only one phosphor, that partially converts blue light to far-red light, or several phosphors, that partially convert blue light to far-red light and red light.

In complete conversion LEDs, when the semiconductor chip generates near-UV emission, the wavelength converter comprises either only one phosphor, that completely converts near-UV emission to only far-red light, or several phosphors, that completely convert near-UV emission to either only far-red light and red light, or only to far-red light and blue light, or to far-red light, red light, and blue light.

In complete conversion LEDs, when the semiconductor chip generates blue light, the wavelength converter comprises either a single phosphor, that completely converts blue light to far-red light, or several phosphors, that completely convert blue light to far-red light and red light.

In partial conversion LEDs, the semiconductor chip emits blue light in the 400-500 nm spectral range and comprises an active layer made of InₓGa₁₋ₓN semiconductor alloy.

In complete conversion LEDs, the semiconductor chip emits at a wavelength shorter than 500 nm and comprises an active layer made of either GaN semiconductor compound or InₓGa₁₋ₓN, AlyGa_{1-y}N, or Al_{y}InₓGa_{1-x-y}N semiconductor alloy.

In all above cases, when a LED emits several spectral components, the fractional photon fluxes and peak wavelengths of each spectral component are selected in such a way that the resulting spectral composition of the emitted light would be suitable for the use separately or in combination with the emission of other sources of light for the best growth and development of particular greenhouse plants, such as lettuce, cucumber, tomato, radish, carrot, onion, cauliflower, broccoli, green pea, wheat and barley grass, etc.

The spectral components of the generated light have the ratios of the fractional photon fluxes as follows:
about 1: 4 for LEDs emitting only far-red light and blue light, respectively,
about 1:15 for LEDs emitting only far-red light and red light, respectively,
about 1:15:4 for LEDs emitting blue light, red light, and far-red light, respectively.

The fractional photon fluxes of each spectral component are predetermined by selecting the size and concentration of the phosphor particles, thickness of the wavelength converter, refraction index of the wavelength converter material, distance of the wavelength converter from the electroluminescent structure, and location of the wavelength converter within the package or outside the package.

In the preferred embodiment of the present invention, the generated spectral components have peak wavelengths as follows:
730±20 nm for the far-red spectral component,
660±20 nm for the red spectral component,
450±20 nm for the blue spectral component.

Besides, the wavelength converter may have an additional phosphor that emits in the yellow, yellow-green, green, or green-blue spectral region in such a way that light emitted by the LED would be perceived by human vision as having a particular chromaticity, e.g., as white light with a preset correlated colour temperature.

The advantages of the proposed invention are listed below, after the detailed explanation of the invention.

### Brief Description of Drawings

The invention is explained in figures that depict the following.
**Fig. 1****.** Basic structure of a plant-cultivation LED with partial conversion of blue light in phosphors.
**Fig. 2****.** Basic structure of a plant-cultivation LED with complete conversion of near-UV light in phosphors.
**Fig. 3****.** Typical electroluminescence spectra of a semiconductor chip with an InGaN active layer: (a) blue emitter; (b) near-UV emitter.
**Fig. 4****.** Typical photoluminescence spectra of inorganic phosphors: (a) far-red emitter; (b) red emitter; (c) blue emitter.
**Fig. 5****.** Emission spectra of plant-cultivation LEDs with partial conversion in phosphors: (a) blue-far-red LED; (b) blue-red-far-red LED.
**Fig. 6****.** Emission spectra of plant-cultivation LEDs with complete conversion in phosphors; (a) far-red LED; (b) blue-far-red LED; (c) red-far-red LED; (d) blue-red-far-red LED.

### Description of Embodiments

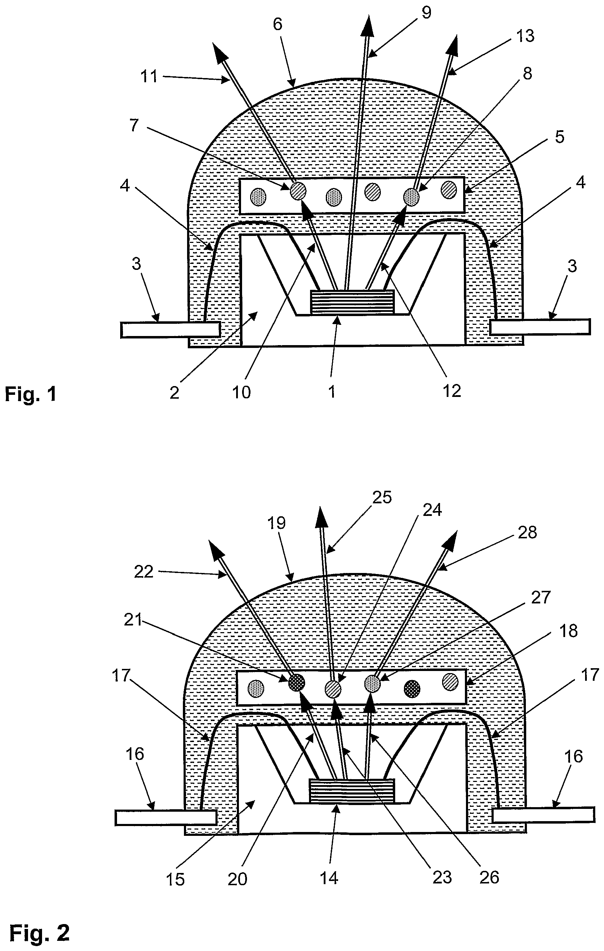

The proposed LED comprises a semiconductor chip 1; 14 (Fig. 1; Fig. 2, respectively) that generates short-wavelength emission at a wavelength shorter than 500 nm due to injection electroluminescence, the chip being placed within a reflector cup 2; 15 and connected to leads 3; 16 using bonded wires 4; 17. The chip 1; 14 is covered by a wavelength converter 5; 18. The chip and converter are encapsulated in the translucent dome 6; 19. The converter is designed for conversion of the said emission to a longer-wavelength emission due to photoluminescence and has at least one type of phosphor particles 7; 21, as well as optional additional phosphor particles 8; 24; 27. Items 9; 10; 11; 12; 13; 20; 22; 23; 25; 26; and 28 denote the photons.

The LED with partial conversion of blue light in phosphor comprises a semiconductor chip 1 (fig. 1) that emits blue light in the spectral range of 400-500 nm, which meets the photomorphogenetic and phototropic needs of plants. This blue light is tailored with the absorption spectra of phosphors contained in the convertor 5. A certain portion of the primary flux is converted by an appropriate phosphor(s) 7 to far-red light in the 700-760 nm spectral range, which corresponds to the absorption spectrum of plant photoreceptor phytochrome of the P_{fr} form.

Meanwhile, the rest portion of the blue light, which meets the photomorphogenetic and phototropic needs of plants, remains not absorbed.

The LED with a complete conversion of near-UV emission in phosphor has a semiconductor chip 14 (Fig. 2) that emits near-UV, violet or blue light with a wavelength shorter than 500 nm. This light is matched to the absorption spectra of the phosphors and is completely converted in the wavelength converter 18. The converter 18 comprises a phosphor 21 that converts the short-wavelength radiation to far-red light in the 700-760 nm spectral range, which corresponds to the absorption spectrum of plant photoreceptor phytochorme of the P_{fr} form.

In addition to phosphors, emitting in the far-red region, the wavelength converter of such LEDs may contain supplementary phosphors 8; 24; and 27, which emit within other spectral ranges that are important for plant growth and development. In plant-growth phosphor- conversion LEDs, numerous available phosphors can be used [Inorganic Phosphors. Compositions. Preparation and Optical Properties, edited by W. M. Yen and M. J. Weber (CRC Press, Boca Raton, 2004), 475 p., ISBN 0849319498; R. Mueller-Mach, G. Mueller, M. R. Krames, H. A. Höppe, F. Stadler, W. Schnick, T. Juestel, and P. Schmidt, Phys. Status Solidi A, 202 (9), pp. 1727-1732 (2005); US Patents No 6,084,250 (2000); No 6,252,254 (2001); No 6,294,800 (2001); No 6,501,102 (2002); No 6,621,211 (2003); No 6,670,748 (2003); No 7,038,370 (2006)]. The position of the spectral peaks and band widths of the phosphors are tailored with the absorption spectra of the phytopigments by selecting the chemical composition of the host crystal and the type of activator ions.

The wavelength converter 5; 18 of the partial- or complete-conversion LEDs may contain a supplementary phosphor 8; 24, which absorbs a portion of the emission with a wavelength shorter than 500 nm and emits red light in the spectral range of 620-680 nm, which meets the photosynthetic and photomorphogenetic needs of plants. Such a phosphor can be an oxide, halooxide, chalcogenide, or nitride compound activated by ions of divalent or tetravalent manganese, divalent or trivalent europium, trivalent bismuth, or divalent tin. For instance, the supplementary red component can be generated in inorganic phosphors, such as Mg₂SiO₄:Mn²⁺, Mg₄(F)GeO₆:Mn²⁺, (Mg,Zn)₃(PO)₄:Mn²⁺, Y₃Al₅O₁₂:Mn⁴⁺, (Ca,Sr,Ba)₂Si₅N₈:Eu²⁺ Sr₂Si₄AlON₇:Eu²⁺, MgO·MgF₂·GeO₂:Eu²⁺, Y₂O₂S:Eu³⁺,Bi³⁺, YVO₄:Eu³⁺,Bi³⁺, Y₂O₃:Eu³⁺,Bi³⁺, SrY₂S₄:Eu²⁺ SrS:Eu²⁺ or MgSr₅(PO)₄:Sn²⁺.

The wavelength converter 18 of the complete-conversion LED may contain a supplementary phosphor 27, which absorbs a portion of the emission with a wavelength shorter than 430 nm and emits blue light in the spectral range of 400-500 nm, which meets the photomorphogenetic and phototropic needs of plants.

Such a phosphor can be an oxide, halooxide, or nitride compound activated by ions of divalent europium, divalent manganese, divalent tin, or trivalent cerium. For instance, the supplementary blue component can be generated in inorganic phosphors, such as CaMgSi₂O₆:Eu²⁺, Ba₅SiO₄Cl₆:Eu²⁺, Mg₃Ca₃(PO₄)₄:Eu²⁺, (Ca,Sr,Ba)₅(PO₄)₃Cl:Eu²⁺, Ca₂B₅O₉(Br,Cl):Eu²⁺, BaMgAl₁₀O₁₇:Eu²⁺, Mn²⁺, BaMg₂Al₁₆O₂₇:Eu²⁺, (Lu,Gd)₂SiO₅:Ce³⁺, Sr₂P₂O₇:Sn²⁺, SrSiAl₂O₃N₂:Ce³⁺, or La₃Si₆N₁₁:Ce³⁺.

The spectrum of light emitted by the partial-conversion LEDs can contain either two components (blue and far-red) or all three components (blue, red, and far-red).

The spectrum of light emitted by the complete-conversion LEDs, which comprise a semiconductor chip 14, generating emission with the wavelength shorter than 430 nm, can contain either one component (far-red), or two components (either blue and far-red or red and far-red), or all three components (blue, red, and far-red).

The spectrum of light emitted by the complete-conversion LEDs, which comprise a semiconductor chip 14 generating emission with the wavelength in the range of 430-500 nm, can contain either one component (far-red) or two components (red and far-red).

A phosphor-conversion LED comprises a common semiconductor chip 1; 14, which contains a p-type layer connected to the anode lead and an n-type layer connected to the cathode electrode 3; 16 that clad an active layer. In the active layer electrons, injected from the n-type cladding layer, radiatively recombine with holes injected from the p-type cladding layer.

The semiconductor chip 1; 14 of the disclosed phosphor-conversion LEDs comprise an active layer that emits either blue or near-UV light. The most appropriate materials for the active layer are group-III nitride compounds of the general formula Al_{y}lnₓGa_{1-x-y}N. These materials feature high chemical and photochemical inertness that determines the longevity of the LEDs. The band structure of these semiconductors (remote indirect valleys) and the peculiarities of carrier recombination result in a weak dependence of output flux on temperature. The thickness of the active layer and the molar fraction of indium and/or aluminium (x and y, respectively) are selected in such a way that the emission band would peak at a required wavelength.

In partial-conversion LEDs, where the semiconductor chip 1 emits in the 400-500 nm wavelength range, the most appropriate material for the active layer is In*ₓ*Ga_{1-*x*}N ternary alloy.

In complete-conversion LEDs, where the semiconductor chip 14 emits at a wavelength shorter than 500 nm, the active layer can be made of either In*ₓ*Ga_{1-*x*}N ternary alloy (370-500 nm wavelength range), or GaN compound (wavelength of about 360 nm), or Al*_{y}*Ga_{1-*y*}N ternary alloy (wavelength shorter than 360 nm). Also, in the entire wavelength range, Al*_{y}*ln*ₓ*Ga_{1-*x*-*y*}N quaternary alloy can be used.

Typically, the chip 1; 14 is mounted within a reflector cup 2; 15 and by using bonded wires 4; 17 is connected to leads 3; 16, which are used to provide the chip with driving current. The wavelength converter 5; 18, which is a layer of epoxy, crystalline or ceramic plate, or plastic mould containing phosphor particles is placed next to the semiconductor chip 1; 14 in such a way that a portion or the entire photon flux generated by the chip would be absorbed by the phosphor particles.

Also, the converter 5; 18 can be placed outside of the LED dome, for instance, the conversion can be performed in the translucent lid of a luminaire coated by phosphor particles.

The wavelength converter 5; 18 is designed in such a way that the wavelengths of the spectral components of the LED emission, as well as the fractional photon fluxes of each spectral component (when several components are emitted), would be the most appropriate for plant cultivation. Plants can be exposed to either solely light of the proposed LEDs or to this light in combination with radiation of other sources. Different greenhouse plants, such as lettuce, cucumber, tomato, radish, carrot, onion, cauliflower, broccoli, green pea, wheat and barley grass, etc. have peculiarities of photosynthesis and photomorphogenesis and different rate of the development of the plant organs (stems, leaves, roots, rhizocarps, blooms, fruits); therefore, they might have different needs in the spectral composition of light. Besides, the optimal spectral composition of light might vary with different stages of the plant development.

Depending on the number and spectral range of the components, the proposed LEDs can be used in various plant illumination systems. For instance, single-component far-red LEDs with complete conversion can substitute for AlGaAs LEDs with the same wavelength in plant-cultivation LED arrays also containing red and blue LEDs. Two-component LEDs with partial or complete conversion that emit in the far-red and blue regions can be used for plant cultivation in combination with red LEDs and high-pressure sodium lamps. Two-component LEDs with complete conversion that emit the far-red and red regions can be used in plant-cultivation facilities that are designed for meeting only photosynthetic and/or phyotochrome-controlled photomorphogenetic needs or in combination with blue LEDs. Finally, three-component phosphor conversion LEDs, which emit within all three spectral ranges important for plant growth and development (far-red, red, and blue), can be used in illuminators designed for versatile plant cultivation, when all photophysiological needs of plants are met.

In average, the optimal composition of light that meets the needs of plants is such that the net photon flux contains about 75% of red light, about 20% of blue light, and about 5% of far-red light. Therefore, in wide-application phosphor-conversion LEDs that emit several spectral components, the fractional fluxes of each component are proposed to be in agreement with these proportions. For instance, for LEDs that emit only far-red and blue light, the corresponding ratio of the fractional fluxes is to be 1:4. For LEDs that emit only far-red and red light, the corresponding ratio of the fractional fluxes is to be 1:15. For three-component LEDs, which emit far-red, red, and blue light, the corresponding ratio of the fractional fluxes is to be 1:15:4.

For two- and three-component LEDs designed for plant cultivation, the fractional fluxes of each component can be set in several ways. For the proposed LEDs, this can be performed by selecting the size and concentration of the phosphor particles, thickness of the wavelength converter, refraction index of the wavelength converter material, distance of the wavelength converter from the electroluminescent structure, and location of the wavelength converter within the package or outside the package.

The optimal spectrum of plant illumination can be attained, when the spectral components of the LEDs are tailored with the optical absorption spectra of plant phytopigments. To that end, the peak position of the far-red component of the proposed LEDs is to be matched with the absorption spectrum of phytochrome of the P_{fr} form at about 730 nm wavelength. The peak position of the supplementary red component is to be matched with the absorption spectrum of chloropylls at about 660 nm wavelength. The peak position of the supplementary blue component is to be matched with the absorption spectrum of carotenoids and cryptochromes at about 450 nm wavelength. Since the absorption spectra of phytopigments are broadened, the indicated preferred wavelengths can differ by ±20 nm.

The visually perceived colour of the above proposed LEDs is red (for one-component far-red and two-component red-far-red LEDs) or purple (for two-component blue-far-red and three-component blue-red-far-red LEDs). Intensive light with such colours can invoke visual discomfort or colour vision disorders for greenhouse workers and for people living in the neighbourhood. Therefore, besides the LEDs emitting the above three components (far-red, red, and blue), LEDs emitting in additional spectral ranges are proposed. For instance, the converter of such LEDs can comprise an additional phosphor (not shown in Fig. 1 and Fig. 2) that emits in the yellow, yellow-green, green, or green-blue ranges. By selecting a fractional flux of the said emission, such LEDs can emit light that would be perceived by human vision as white light with a certain chromaticity, e.g., as white light with a predetermined correlated colour temperature.

The phosphor-conversion LEDs for plant cultivation according to the present invention are advantageous in respect of closest prior art [US Patent No 5,998,925 (1999)], as well as in respect of other white LEDs [US Patents No 6,084,250 (2000); 6,294,800 (2001); 6,501,102 (2002); 6,504,179 (2003), etc.] in that they generate a spectral component with the peak in the far-red region, which is necessary for the excitation of phytochrome of P_{fr} form.

The proposed phosphor-conversion LEDs for plant cultivation also are advantageous in respect to known sources of light that have emission spectra optimized in order to meet photophysiological needs of plants.

The disclosed phosphor-conversion LED for plant cultivation is advantageous in respect of prior art related to plant-cultivation fluorescent lamps [US Patents No 3,287,586 (1963); 3,992,646 (1976); 4,371,810 (1983); 5,525,860 (1996); and 7,259,509 (2007)] in potentially higher efficiency. For instance, blue InGaN chips with the radiant efficiency of 70% are feasible [J. M. Phillips, M. E. Coltrin, M. H. Crawford, A. J. Fischer, M. R. Krames, R. Mueller-Mach, G. O. Mueller, Y. Ohno, L. E. S. Rohwer, J. A. Simmons, and J. Y. Tsao, Laser & Photon. Rev 1 (4), pp. 307-333 (2007)]. With a much smaller Stokes shift in conversion of blue (450-nm) light to far-red light (730-nm) taken into account, a phosphor-conversion LED emitting far-red light can have the overall energy-conversion efficiency of about 43%, i.e. almost twice as higher as that of a fluorescent lamp (22%).

Correspondingly, the efficiency of generation of supplementary red and blue components is higher. Other advantages of phosphor-conversion LEDs in respect of fluorescent lamps are mechanical robustness, compactness, longevity (up to 100 000 hours), fast switching, no abrupt failure, low operation voltage (2-4 V), compatibility with computer electronics, narrow-band emission without undesired spectral components, freedom from hazardous materials (mercury), and flexibility in terms of assembling into arrays of different shape.

The disclosed phosphor-conversion LEDs for plant cultivation are also advantageous in respect of purely electroluminescent LED arrays [US Patent No 5,012,609 (1991)]. When the far-red spectral component is generated within a single-component phosphor-conversion LED with complete conversion, the advantage is in the use of InGaN semiconductor chip, which in comparison with the presently used AlGaAs semiconductor has a higher radiant efficiency, higher thermal stability of the output flux, and higher resistivity against corrosion. When the far-red spectral component is generated within a multi-component phosphor-conversion LED with partial or complete conversion, in addition to the above advantage, single-channel driving electronics can be used. When the phosphor-conversion LED emits in all three spectral regions important for plant growth and development, in addition to the above advantages, irradiances due to different spectral components with predetermined fractional fluxes are much easier to evenly distribute over plants thus avoiding complex topologies for assembling different groups of the coloured LEDs and adjustment of driving currents for each group of the LEDs.

Figure 1 shows the basic structure of a plant-cultivation LED with partial conversion of blue light. The LED comprises a semiconductor chip 1, which generates blue light due to injection electroluminescence. The chip is placed in a reflector cup 2 and connected to leads 3 using bonded wires 4. The chip is covered by a wavelength converter 5. The chip and converter are encapsulated in the translucent dome 6, such as plastic or silicone mould. Typically the semiconductor chip contains a p-type layer connected to the anode lead and an n-type layer connected to the cathode electrode that clad an active layer. In the active layer, electrons injected from the n-type cladding layer radiatively recombine with holes injected from the p-type cladding layer. A typical material for the active layer is In*ₓ*Ga_{1-*x*}N ternary alloy with the thickness of the active layer and the molar fraction of indium in the alloy x selected in such a way that the emission band has a peak in the spectral range of 400-500 nm.

Light generated by the semiconductor chip 1 passes through the wavelength converter 5, which contains phosphor particles 7 of the first kind and, additionally, phosphor particles 8 of the second kind (Fig. 1 shows the case with both kinds of phosphor particles used). Photons emitted from the semiconductor chip have two possible destinies. A photon shown in Fig. 1 by arrow 9 is not absorbed in the phosphor particles and escapes from the chip to the environment through the encapsulant. A photon shown by arrow 10 is absorbed in a phosphor particle 7 of first kind and converted to a photon 11 with the wavelength corresponding to the spectral component with a peak in the 700-760 nm (far-red) spectral range. Meanwhile, a photon shown by arrow 12 is absorbed in a phosphor particle 8 of the second kind and converted to a photon 13 with the wavelength falling into the 620-680 nm (far-red) spectral range. Eventually, the LED emits light containing at least two spectral components relevant to plant photophysiology. A LED with the converter 5, containing only phosphor particles 7 of the first kind, emits two-component blue-far-red light and a LED, containing phosphor particles 7 and 8 of both kinds, emits three-component blue-red-far-red light.

Figure 2 shows the basic structure of a plant-cultivation LED with complete conversion of near-UV emission. The LED comprises a semiconductor chip 14, which generates near-UV light due to injection electroluminescence. The chip is placed in a reflector cup 15 and connected to leads 16 using bonded wires 17. The chip is covered by a wavelength converter 18. The chip 14 and converter 18 are encapsulated in a translucent dome 19. Typically the semiconductor chip contains a p-type layer connected to the anode lead and an n-type layer connected to the cathode electrode that clad an active layer. In the active layer, electrons injected from the n-type cladding layer radiatively recombine with holes injected from the p-type cladding layer. A typical material for the active layer is either GaN binary semiconductor or In*ₓ*Ga_{1-*x*}N or Al*_{y}*Ga_{1-*y*}N ternary alloys or In*ₓ*Al*_{y}*Ga_{1-*x*-*y*}N quaternary alloy, when the thickness of the active layer and the molar fractions of indium and aluminium in the alloys *x* and *y*, respectively, are selected in such a way that the emission band has a peak at wavelengths shorter than 430 nm.

Light generated by the semiconductor chip 14 passes through the wavelength converter 18, which contains phosphor particles of the first kind 21 and, additionally, phosphor particles 8 of the second kind 24 and/or phosphor particles of the third kind 27 (Fig. 2 shows the case with three kinds of phosphor particles used). All photons emitted from the semiconductor chip are absorbed in the phosphor particles. A photon shown in Fig. 2 by arrow 20 is absorbed in a phosphor particle 21 of the first kind and converted to a photon 22 with the wavelength corresponding to the spectral component with a peak in the 700-760 nm (far-red) spectral range. A photon shown by arrow 23 is absorbed in a phosphor particle 24 of the second kind and converted to a photon 25 with the wavelength falling into the spectral range of 620-680 nm (red). Meanwhile a photon shown by arrow 26 is absorbed in a phosphor particle 27 of the third kind and converted to a photon 28 with the wavelength falling into the spectral range of 400-500 nm (blue). Eventually, the LED emits light containing at least one spectral component relevant to plant photophysiology. A LED with the converter 18, containing only phosphor particles 21 of the first kind, emits only far-red light; a LED with the converter 18, containing only phosphor particles 21 of the first kind and phosphor particles 24 of the second kind, emits two-component red-far-red light; a LED with the converter 18, containing only phosphor particles 21 of the first kind and phosphor particles 27 of the third kind, emits two-component blue-far-red light; and a LED with the converter 18 containing phosphor particles 21, 24, and 27 of all three kinds emit three-component blue-red-far-red light.

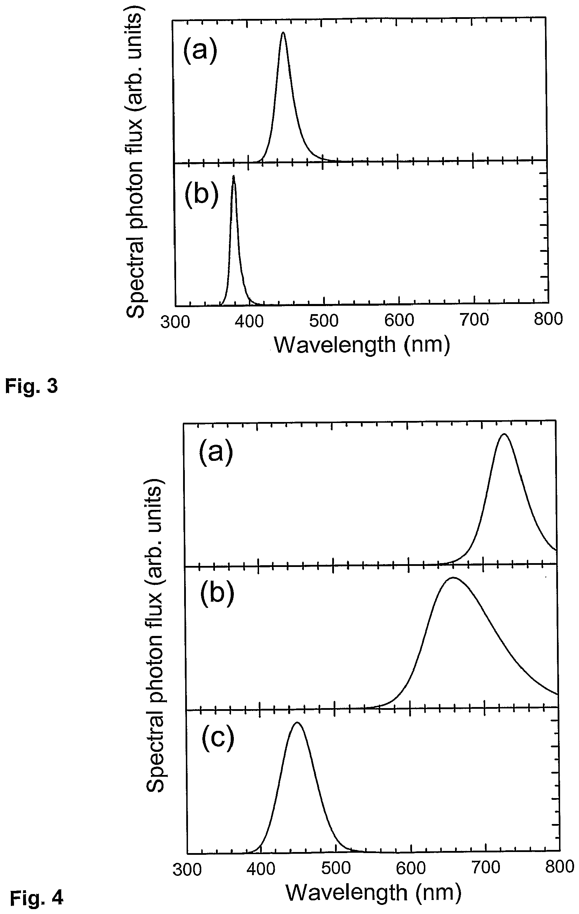

Figure 3 shows possible electroluminescence spectra of semiconductor chips that are proposed for using in phosphor-conversion LEDs for plant cultivation. In LEDs both with partial and complete conversion, the electroluminescence spectra must be matched with the absorption spectra of the phosphors. In addition in LEDs with partial conversion, the electroluminescence spectra is to be tailored to meet photophysiological needs of plants in the spectral range of 400-500 nm.

Figure 3 (a) depicts an electroluminescence spectrum of a semiconductor chip with an active layer made of In*ₓ*Ga_{1-*x*}N ternary alloy with the thickness of the active layer and the molar fraction of indium in the alloy selected in such a way that the emission band has a peak at 450 nm in the blue spectral region. Such a chip can be used in a plant-cultivation LED with partial conversion. Figure 3 (b) shows an electroluminescence spectrum of a semiconductor chip with an active layer made of In*ₓ*Ga_{1-*x*}N ternary alloy with the thickness of the active layer and the molar fraction of indium x in the alloy selected in such a way that the emission band has a peak at 380 nm in the near-UV spectral region. Such a chip can be used in a plant-cultivation LED with complete conversion.

Figure 4 shows individual photoluminescence spectra of possible phosphors for use in plant-cultivation phosphor-conversion LEDs. Figure 4 (a) shows the photoluminescence spectrum of a gadolinium-gallium oxyde phosphor activated by trivalent chromium ions [Gd₃Ga₅O₁₂:Cr³⁺], which absorbs blue or near-UV light and emits far-red light within a spectral band peaked at about 730 nm. Such a phosphor can be used in plant-cultivation LEDs with either partial or complete conversion for the generation of the far-red spectral component. Figure 4 (b) shows the photoluminescence spectrum of a nitridosilicate phosphor activated by divalent europium ions [(Ca,Sr,Ba)₂Si₅N₈:Eu²⁺], which absorbs blue or near-UV light and emit red light within a spectral band peaked at about 660 nm. Such a phosphor can be used in plant cultivation LEDs with either partial or complete conversion for the generation of the red spectral component. Figure 4 (c) shows the photoluminescence spectrum of an aluminate phosphor activated by divalent europium ions (BaMgAl₁₀O₁₇:Eu²⁺), which absorbs near-UV light and emit blue light within a spectral band peaked at 450 nm. Such a phosphor can be used in plant-cultivation LEDs with complete conversion for the generation of the blue spectral component.

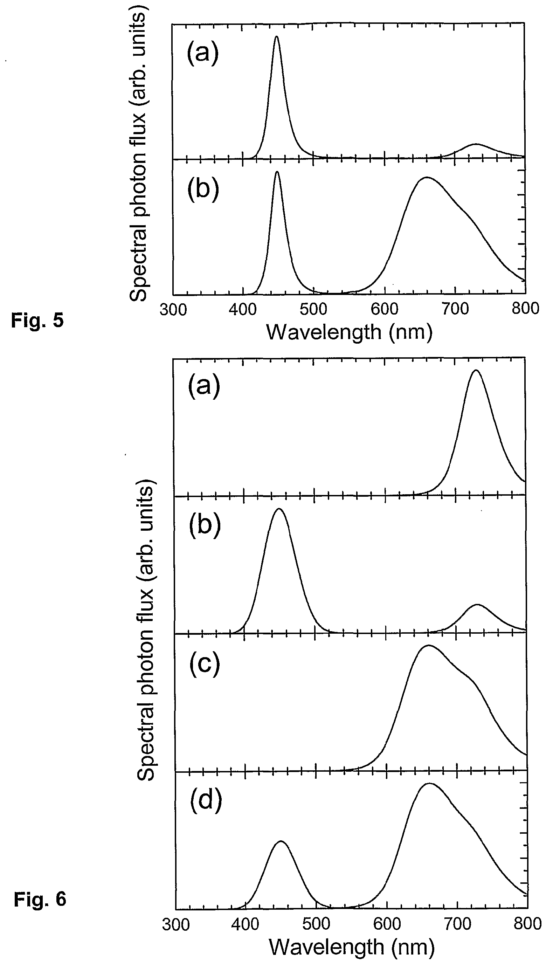

Figure 5 shows emission spectra of the proposed plant-cultivation LEDs with partial conversion. All spectra contain a blue spectral component with the peak at 450 nm that is generated by an InGaN semiconductor chip due to injection electroluminescence and a far-red spectral component due to photoluminescence of the wavelength converter. The fractional fluxes of the residual blue light and light generated by each phosphor are controlled by the concentration of the phosphor particles, thickness of the wavelength converter, refraction index of the wavelength converter materials, distance of the wavelength converter from the semiconductor chip, and location of the wavelength converter in the package. Figure 5 (a) shows a spectrum of two-component blue-far-red light that is generated by partial conversion of blue light due to electroluminescence in a Gd₃Ga₅O₁₂:Cr³⁺ phosphor, which emits far-red light due to photoluminescence. The fractional photon fluxes of the blue and far-red components are 80% and 20%, respectively. Such blue-far-red LEDs can be used in complementary lighting systems that contain other sources that invoke photosynthesis in chlorophylls, such as high-pressure sodium lamps. Figure 5 (b) shows a spectrum of three-component blue-red-far-red light that is generated due to partial conversion of blue light due to electroluminescence in (Ca,Sr,Ba)₂Si₅N₈:Eu²⁺ and Gd₃Ga₅O₁₂:Cr³⁺ phosphors, which emit red and far-red light, respectively, due to photoluminescence. The fractional photon fluxes of the blue, red, and far-red components are 20%, 75%, and 5%, respectively. Such blue-red-far-red LEDs can be used for versatile cultivation of plants with all photophysiological needs of plants met.

Figure 6 shows emission spectra of the proposed plant-cultivation LEDs with complete conversion. All such LEDs, which contain a semiconductor chip that generates near-UV light with the wavelengths shorter than 430 nm due to injection electroluminescence, emit at least one longer-wavelength component due to photoluminescence of phosphors. The fractional fluxes generated by each phosphor are controlled by the concentration of the phosphor particles, thickness of the wavelength converter, refraction index of the wavelength converter materials, distance of the wavelength converter from the semiconductor chip, and location of the wavelength converter within the package or outside the package. Figure 6 (a) shows a spectrum of one-component far-red light that is generated by complete conversion of near-UV light due to electroluminescence in a Gd₃Ga₅O₁₂:Cr³⁺ phosphor, which emits far-red light due to photoluminescence. Such a far-red LED can be used for plant cultivation in combination with other sources of light that lack emission at 730 nm. Figure 6 (b) shows a spectrum of two-component blue-far-red light that is generated by complete conversion of near-UV light due to electroluminescence in BaMgAl₁₀O₁₇:Eu²⁺ and Gd₃Ga₅O₁₂:Cr³⁺ phosphors, which emit blue and far-red light, respectively, due to photoluminescence. The fractional photon fluxes of the blue and far-red components are 80% and 20%, respectively. Such blue-far-red LEDs can be used in complementary lighting systems that contain other sources that invoke photosynthesis in chlorophylls, such as high-pressure sodium lamps. Figure 6 (c) shows a spectrum of two-component red-far-red light that is generated by complete conversion of near-UV light due to electroluminescence in (Ca,Sr,Ba)₂Si₅N₈:Eu²⁺ and Gd₃Ga₅O₁₂:Cr³⁺ phosphors, which emit red and far-red light, respectively, due to photoluminescence. The fractional photon fluxes of the red and far-red components are 90% and 10%, respectively. Such red-far-red LEDs can be used in plant growth facilities that are designed for meeting only photosynthetic and/or phytochrome-controlled photomorphogenetic needs of plants. Figure 6 (d) shows a spectrum of three-component blue-red-far-red light that is generated by complete conversion of near-UV light due to electroluminescence in BaMgAl₁₀O₁₇:Eu²⁺, (Ca,Sr,Ba)₂Si₅N₈:Eu²⁺, and Gd₃Ga₅O₁₂:Cr³⁺ phosphors, which emit blue, red, and far-red light, respectively, due to photoluminescence. The fractional photon fluxes of the blue, red, and far-red components are 20%, 75%, and 5%, respectively. Such blue-red-far-red LEDs can be used for versatile cultivation of plants with all photophysiological needs met.

## Claims

1. A light emitting diode, comprising a package housing a semiconductor chip (1; 14), which generates short-wavelength emission at a wavelength shorter than 500 nm due to injection electroluminescence, and a converter (5; 18), placed on the way of the photon flux generated by the chip (1; 14), the said converter (5; 18) being designed for the conversion of the said emission to longer wavelengths due to photoluminescence and containing phosphor particles of at least one kind, wherein the converter (5; 18) comprises a phosphor (7; 21), emitting within a spectral band, peaking in the far-red region from 700 nm to 760 nm, which corresponds to the absorption spectrum of phytochrome of the P_{fr} form,
**characterised in that**
said phosphor is
- gadolinium-gallium oxide activated by trivalent chromium and/or trivalent cerium ions, or
- calcium sulphide activated by divalent ytterbium ions.

2. A light-emitting diode according to claim 1, **characterised in that** the semiconductor chip (1) generates blue light in the 400-500 nm spectral range, which meets photomorphogenetic and phototropic needs of plants, and the converter (5) converts a portion of the said light to longer-wavelength light.

3. A light-emitting diode according to claim 1, **characterised in that** the semiconductor chip (14) generates near-UV emission of wavelength shorter than 360 nm or blue emission of wavelength range from 400 nm to 500 nm and the converter (18) completely converts the said light to longer-wavelength light.

4. A light-emitting diode according to claim 2 or 3 **characterised in that** its wavelength converter (5;18) comprises a supplementary phosphor (8; 24), emitting red light in the 620-680 nm spectral range, which meets photosynthetic and photomorphogenetic needs of plants, said phosphor being such as oxide, halooxide, chalcogenide, or nitride compound, activated by divalent or tetravalent manganese, divalent or trivalent europium, trivalent bismuth, or divalent tin ions.

5. A light-emitting diode according to claim 3 **characterised in that** the wavelength converter (18) comprises a supplementary phosphor (27), emitting blue light in the 400-500 nm spectral range, which meets photomorphogenetic and phototropic needs of plants, said phosphor being such as oxide, halooxide, or nitride compound, activated by divalent europium, divalent manganese, divalent tin or trivalent cerium ions.

6. A light-emitting diode according to claim 2 **characterised in that** the wavelength converter (5) comprises either a single phosphor (7), partially converting blue light to far-red light, or several phosphors (7,8), partially converting blue light to far-red light and red light.

7. A light-emitting diode according to claim 3 **characterised in that** its wavelength converter (18) comprises either a single phosphor (21), completely converting near-UV emission of wavelength shorter than 360 nm to only far-red light, or several phosphors (21; 24; 27), completely converting near-UV emission of wavelength shorter than 360 nm to only far-red light and red light (21; 24), or only to far-red light and blue light (21; 27), or to far-red light, red light, and blue light (21; 24; 27).

8. A light-emitting diode according to claim 3 **characterised in that** the wavelength converter (18) comprises either a single phosphor (21), completely converting blue light to only far-red light, or several phosphors (21; 24), completely converting blue light to far-red light and red light.

9. A light-emitting diode according to claim 2 **characterised in that** the semiconductor chip (1) emits in the spectral range of 400-500 nm and comprises an active layer made of InₓGa₁₋ₓN semiconductor alloy.

10. A light-emitting diode according to claim 3 **characterised in that** the semiconductor chip (14) emits in the spectral range of 400-500 nm or shorter than 360 nm and comprises an active layer made of either GaN semiconductor compound or In*ₓ*Ga_{1-*x*}N, Al*_{y}*Ga_{1-*y*}N, or In*ₓ*Al*_{y}*Ga_{1-*x*-*y*}N semiconductor alloy.

11. A light-emitting diode according to claim 2 or 3, **characterised in that** the fractional photon fluxes and peak wavelengths of each spectral component are selected in such a way that the resulting spectral composition of the emitted light would be suitable for use separately or in combination with the emission of other sources of light for the best growth and development of particular greenhouse plants, such as lettuce, cucumber, tomato, radish, carrot, onion, cauliflower, broccoli, green pea, wheat or barley grass, etc.

12. A light-emitting diode according to claim 2 or 3 **characterised in that** the spectral components of the generated light have the ratios of the fractional photon fluxes as follows:
about 1:4 for light-emitting diodes emitting only far-red and blue light, respectively,
about 1:15 for light-emitting diodes emitting only far-red and red light, respectively,
about 1:15:4 for light-emitting diodes emitting far-red, red and blue light, respectively.

13. A light-emitting diode according to claim 2 or 3 **characterised in that** the fractional fluxes of each spectral component are predetermined by selecting the size and concentration of the phosphor (7; 8; 21; 24; 27) particles, thickness of the wavelength converter (5; 18), refraction index of the wavelength converter materials, distance of the wavelength converter from the electroluminescent structure (1;14), and location of the wavelength converter within the package or outside the package.

14. A light-emitting diode according to claim 2 or 3 **characterised in that** the generated spectral components have peak wavelengths as follows:
730±20 nm for the far-red spectral component,
660±20 nm for the red spectral component,
450±20 nm for the blue spectral component.

15. A light-emitting diode according to claim 6, 7, or 8 **characterised in that** its wavelength converter (5; 18) comprises an additional phosphor that emits in the yellow, yellow-green, green, or green-blue spectral region in such a way that light emitted by the light-emitting diode is perceived by human vision as having a particular chromaticity, e.g., as white light with a preset correlated colour temperature.

## Patentansprüche

1. Leuchtdiode, umfassend ein Packungsgehäuse, einen Halbleiterchip (1; 14), der Emission kurzer Wellenlänge bei einer kürzeren Wellenlänge als 500 nm aufgrund von Injektionselektrolumineszenz erzeugt, und einen Konverter (5; 18), der auf dem Weg des Photonenfluss angeordnet ist, der durch den Chip (1; 14) erzeugt wird, wobei der Konverter (5; 18) zur Konversion der Emission in längere Wellenlängen aufgrund von Photolumineszenz ausgelegt ist und Phosphorpartikel mindestens einer Art enthält, wobei der Konverter (5; 18) einen Phosphor (7; 21) umfasst, der innerhalb eines Spektralbandes mit einer Spitze in der fernroten Region von 700 nm bis 760 nm emittiert, die dem Absorptionsspektrum von Phytochrom of der P_{fr}-Form entspricht,
**dadurch gekennzeichnet, dass**
es sich bei dem Phosphor handelt um:
- Gadolinium-Galliumoxid, aktiviert durch dreiwertiges Chrom und/oder dreiwertige Cer-Ionen, oder
- Calciumsulfid, aktiviert durch zweiwertige Ytterbium-Ionen.

2. Leuchtdiode nach Anspruch 1, **dadurch gekennzeichnet, dass** der Halbleiterchip (1) blaues Licht im Spektralbereich von 400 bis 500 nm erzeugt, der photomorphogenetische und phototrope Bedürfnisse von Pflanzen erfüllt, und der Konverter (5) einen Teil des Lichts in Licht längerer Wellenlänge konvertiert.

3. Leuchtdiode nach Anspruch 1, **dadurch gekennzeichnet, dass** der Halbleiterchip (14) Nah-UV-Emission einer kürzeren Wellenlänge als 360 nm oder Blau-Emission eines Wellenlängenbereichs von 400 nm bis 500 nm erzeugt, und der Konverter (18) das Licht vollständig in Licht längerer Wellenlänge konvertiert.

4. Leuchtdiode nach Anspruch 2 oder 3, **dadurch gekennzeichnet, dass** ihr Wellenlängenkonverter (5; 18) einen zusätzlichen Phosphor (8; 24) umfasst, der rotes Licht im Spektralbereich von 620 bis 680 nm emittiert, der photosynthetische und photomorphogenetische Bedürfnisse von Pflanzen erfüllt, wobei es sich bei dem Phosphor beispielsweise um eine Oxid-, Halooxid-, Chalkogenid- oder Nitridverbindung handelt, die durch zweiwertiges oder vierwertiges Mangan, zweiwertiges oder dreiwertiges Europium, dreiwertiges Bismut oder zweiwertige Zinn-Ionen aktiviert wird.

5. Leuchtdiode nach Anspruch 3, **dadurch gekennzeichnet, dass** der Wellenlängenkonverter (18) einen zusätzlichen Phosphor (27) umfasst, der blaues Licht im Spektralbereich von 400 bis 500 nm emittiert, der photomorphogenetische und phototrope Bedürfnisse von Pflanze erfüllt, wobei es sich bei dem Phosphor beispielsweise um eine Oxid-, Halooxid- oder Nitridverbindung handelt, die durch zweiwertiges Europium, zweiwertiges Mangan, zweiwertiges Zinn oder dreiwertige Cer-Ionen aktiviert wird.

6. Leuchtdiode nach Anspruch 2, **dadurch gekennzeichnet, dass** der Wellenlängenkonverter (5) entweder einen einzigen Phosphor (7), der blaues Licht teilweise in fernrotes Licht konvertiert, oder mehrere Phosphore (7, 8) umfasst, die blaues Licht teilweise in fernrotes Licht und rotes Licht konvertieren.

7. Leuchtdiode nach Anspruch 3, **dadurch gekennzeichnet, dass** sein Wellenlängenkonverter (18) entweder einen einzigen Phosphor (21), der Nah-UV-Emission einer kürzeren Wellenlänge als 360 nm vollständig in nur fernrotes Licht konvertiert, oder mehrere Posphore (21; 24; 27) umfasst, die Nah-UV-Emission einer kürzeren Wellenlänge als 360 nm vollständig in nur fernrotes Licht und rotes Licht (21; 24) oder nur in fernrotes Licht und blaues Licht (21; 27) oder in fernrotes Licht, rotes Licht und blaues Licht (21; 24; 27) konvertieren.

8. Leuchtdiode nach Anspruch 3, **dadurch gekennzeichnet, dass** der Wellenlängenkonverter (18) entweder einen einzigen Phosphor (21), der blaues Licht vollständig in nur fernrotes Licht konvertiert, oder mehrere Phosphore (21, 24) umfasst, die blaues Licht vollständig in fernrotes Licht und rotes Licht konvertieren.

9. Leuchtdiode nach Anspruch 2, **dadurch gekennzeichnet, dass** der Halbleiterchip (1) im Spektralbereich von 400 bis 500 nm emittiert und eine aktive Schicht umfasst, die aus einer InₓGa₁₋ₓN-Halbleiterlegierung hergestellt ist.

10. Leuchtdiode nach Anspruch 3, **dadurch gekennzeichnet, dass** der Halbleiterchip (14) im Spektralbereich von 400 bis 500 nm oder kürzer als 360 nm emittiert und eine aktive Schicht umfasst, die entweder aus einer GaN-Halbleiterverbindung oder InₓGa₁₋ₓN, AlyGa_{1-y}N oder einer InₓAl_{y}Ga_{1-x-y}N-Halbleiterlegierung hergestellt ist.

11. Leuchtdiode nach Anspruch 2 oder 3, **dadurch gekennzeichnet, dass** die fraktionierten Photonenflüsse und die Spitzenwellenlängen jeder Spektralkomponente derart ausgewählt sind, dass die resultierende Spektralzusammensetzung des emittierten Lichts zur Verwendung getrennt oder in Kombination mit der Emission anderer Lichtquellen für das beste Wachstum und die beste Entwicklung bestimmter Gewächshauspflanzen, wie beispielsweise Kopfsalat, Gurke, Tomate, Rettich, Karotte, Zwiebel, Blumenkohl, Broccoli, grüne Erbse, Weizen oder Gerste usw., geeignet wäre.

12. Leuchtdiode nach Anspruch 2 oder 3, **dadurch gekennzeichnet, dass** die Spektralkomponenten des erzeugten Lichts die folgenden Verhältnisse der fraktionierten Photonenflüsse aufweisen:
etwa 1:4 für Leuchtdioden, die nur fernrotes bzw. blaues Licht emittieren,
etwa 1:15 für Leuchtdioden, die nur fernrotes bzw. rotes Licht emittieren,
etwa 1:15:4 für Leuchtdioden, die fernrotes, rotes bzw. blaues Licht emittieren.

13. Leuchtdiode nach Anspruch 2 oder 3, **dadurch gekennzeichnet, dass** die fraktionierten Flüsse jeder Spektralkomponente durch Auswählen der Größe und Konzentration der Partikel von Phosphor (7; 8; 21; 24; 27), der Dicke des Wellenlängenkonverters (5; 18), des Brechungsindexes des Wellenlängenkonvertermaterials, des Abstands des Wellenlängenkonverters von der elektrolumineszierenden Struktur (1; 14) und der Position des Wellenlängenkonverters innerhalb der Packung oder außerhalb der Packung im Voraus bestimmt werden.

14. Leuchtdiode nach Anspruch 2 der 3, **dadurch gekennzeichnet, dass** die erzeugten Spektralkomponenten die folgenden Spitzenwellenlängen aufweisen:
730 ± 20 nm für die fernrote Spektralkomponente,
660 ± 20 nm für die rote Spektralkomponente,
450 ± 20 nm für die blaue Spektralkomponente.

15. Leuchtdiode nach Anspruch 6, 7 oder 8, **dadurch gekennzeichnet, dass** ihr Wellenlängenkonverter (5; 18) einen zusätzlichen Phosphor umfasst, der in der gelben, gelbgrünen, grünen oder grünblauen Spektralregion emittiert, derart dass Licht, das durch die Leuchtdiode emittiert wird, vom menschlichen Auge als eine bestimmte Chromatizität aufweisend, z. B. als weißes Licht mit einer voreingestellten korrelierten Farbtemperatur, wahrgenommen wird.

## Revendications

1. Diode électroluminescente, comprenant un boîtier abritant une puce semi-conductrice (1 ; 14), qui génère une émission de courte longueur d'onde à une longueur d'onde plus courte que 500 nm du fait de l'électroluminescence par injection, et un convertisseur (5 ; 18) placé sur la trajectoire du flux de photons généré par la puce (1 ; 14), ledit convertisseur (5 ; 18) étant conçu pour la conversion de ladite émission en longueurs d'onde plus longues du fait de la photoluminescence et contenant des particules de luminophore d'au moins un type, le convertisseur (5 ; 18) comprenant un luminophore (7 ; 21) émettant à l'intérieur d'une bande spectrale atteignant un maximum dans la région du rouge lointain de 700 nm à 760 nm, qui correspond au spectre d'absorption d'un phytochrome de la forme P_{fr},
**caractérisée en ce que** ledit luminophore est
- de l'oxyde de gadolinium-gallium activé par des ions chrome trivalents et/ou cérium trivalents, ou
- du sulfure de calcium activé par des ions ytterbium divalents.

2. Diode électroluminescente selon la revendication 1, **caractérisée en ce que** la puce semi-conductrice (1) génère de la lumière bleue dans le domaine spectral de 400-500 nm, qui répond aux besoins photomorphogénétiques et phototropiques de plantes, et le convertisseur (5) convertit une partie de ladite lumière en lumière de longueur d'onde plus longue.

3. Diode électroluminescente selon la revendication 1, **caractérisée en ce que** la puce semi-conductrice (14) génère une émission dans le proche UV de longueur d'onde plus courte que 360 nm ou une émission bleue d'une gamme de longueurs d'onde de 400 nm à 500 nm et le convertisseur (18) convertit entièrement ladite lumière en lumière de longueur d'onde plus longue.

4. Diode électroluminescente selon la revendication 2 ou 3 **caractérisée en ce que** son convertisseur de longueur d'onde (5 ; 18) comprend un luminophore supplémentaire (8 ; 24) émettant de la lumière rouge dans le domaine spectral de 620-680 nm, qui répond aux besoins photosynthétiques et photomorphogénétiques de plantes, ledit luminophore étant tel qu'un composé oxyde, oxyhalogénure, chalcogénure ou nitrure, activé par des ions manganèse divalents ou tétravalents, europium divalents ou trivalents, bismuth trivalents ou étain divalents.

5. Diode électroluminescente selon la revendication 3 **caractérisée en ce que** le convertisseur de longueur d'onde (18) comprend un luminophore supplémentaire (27) émettant de la lumière bleue dans le domaine spectral de 400-500 nm, qui répond aux besoins photomorphogénétiques et phototropiques de plantes, ledit luminophore étant tel qu'un composé oxyde, oxyhalogénure ou nitrure, activé par des ions europium divalents, manganèse divalents, étain divalents ou cérium trivalents.

6. Diode électroluminescente selon la revendication 2 **caractérisée en ce que** le convertisseur de longueur d'onde (5) comprend un seul luminophore (7) convertissant partiellement la lumière bleue en lumière dans le rouge lointain, ou plusieurs luminophores (7, 8) convertissant partiellement la lumière bleue en lumière dans le rouge lointain et en lumière rouge.

7. Diode électroluminescente selon la revendication 3 **caractérisée en ce que** son convertisseur de longueur d'onde (18) comprend un seul luminophore (21) convertissant entièrement l'émission dans le proche UV de longueur d'onde plus courte que 360 nm uniquement en lumière dans le rouge lointain, ou plusieurs luminophores (21 ; 24 ; 27) convertissant entièrement l'émission dans le proche UV de longueur d'onde plus courte que 360 nm uniquement en lumière dans le rouge lointain et en lumière rouge (21 ; 24), ou uniquement en lumière dans le rouge lointain et en lumière bleue (21 ; 27), ou en lumière dans le rouge lointain, en lumière rouge et en lumière bleue (21 ; 24 ; 27).

8. Diode électroluminescente selon la revendication 3 **caractérisée en ce que** le convertisseur de longueur d'onde (18) comprend un seul luminophore (21) convertissant entièrement la lumière bleue uniquement en lumière dans le rouge lointain, ou plusieurs luminophores (21 ; 24) convertissant entièrement la lumière bleue en lumière dans le rouge lointain et en lumière rouge.

9. Diode électroluminescente selon la revendication 2 **caractérisée en ce que** la puce semi-conductrice (1) émet dans le domaine spectral de 400-500 nm et comprend une couche active constituée d'un alliage semi-conducteur InₓGa₁₋ₓN.

10. Diode électroluminescente selon la revendication 3 **caractérisée en ce que** la puce semi-conductrice (14) émet dans le domaine spectral de 400-500 nm ou plus court que 360 nm et comprend une couche active constituée d'un composé semi-conducteur GaN ou d'un alliage semi-conducteur InₓGa₁₋ₓN, Al_{y}Ga_{1-y}N ou InₓAl_{y}Ga_{1-x-y}N.

11. Diode électroluminescente selon la revendication 2 ou 3, **caractérisée en ce que** les flux fractionnels de photons et les longueurs d'onde de crête de chaque composante spectrale sont choisis de telle sorte que la composition spectrale résultante de la lumière émise serait appropriée pour être utilisée séparément ou en combinaison avec l'émission d'autres sources de lumière pour la meilleure croissance et le meilleur développement de plantes de serre particulières, telles que la laitue, le concombre, la tomate, le radis, la carotte, l'oignon, le chou-fleur, le brocoli, le petit pois, le blé ou l'orge, etc.

12. Diode électroluminescente selon la revendication 2 ou 3 **caractérisée en ce que** les composantes spectrales de la lumière générée ont les proportions des flux fractionnels de photons suivantes :
environ 1:4 pour des diodes électroluminescentes émettant uniquement de la lumière dans le rouge lointain et bleue, respectivement,
environ 1:15 pour des diodes électroluminescentes émettant uniquement de la lumière dans le rouge lointain et rouge, respectivement,
environ 1:15:4 pour des diodes électroluminescentes émettant de la lumière dans le rouge lointain, rouge et bleue, respectivement.

13. Diode électroluminescente selon la revendication 2 ou 3 **caractérisée en ce que** les flux fractionnels de chaque composante spectrale sont prédéterminés en choisissant la taille et la concentration des particules de luminophore (7 ; 8 ; 21 ; 24 ; 27), l'épaisseur du convertisseur de longueur d'onde (5 ; 18), l'indice de réfraction des matériaux du convertisseur de longueur d'onde, la distance entre le convertisseur de longueur d'onde et la structure électroluminescente (1 ; 14), et l'emplacement du convertisseur de longueur d'onde à l'intérieur du boîtier ou à l'extérieur du boîtier.

14. Diode électroluminescente selon la revendication 2 ou 3 **caractérisée en ce que** les composantes spectrales générées ont des longueurs d'onde de crête comme suit :
730±20 nm pour la composante spectrale dans le rouge lointain,
660±20 nm pour la composante spectrale rouge,
450±20 nm pour la composante spectrale bleue.

15. Diode électroluminescente selon la revendication 6, 7 ou 8 **caractérisée en ce que** son convertisseur de longueur d'onde (5 ; 18) comprend un luminophore supplémentaire qui émet dans la région spectrale jaune, jaune-verte, verte ou verte-bleue de telle sorte que la lumière émise par la diode électroluminescente est perçue par la vision humaine comme ayant une chromaticité particulière, par ex. comme une lumière blanche avec une température de couleur corrélée préréglée.
